Europäisches Patentamt

(19) European Patent Office  (11) Veröffentlichungsnummer: **0 054 710**
**B1**

Office européen des brevets

(12) **EUROPÄISCHE PATENTSCHRIFT**

(45) Veröffentlichungstag der Patentschrift:
05.02.86

(21) Anmeldenummer: 81109166.9

(22) Anmeldetag: 29.10.81

(51) Int. Cl.⁴: **H 01 J 37/304,** G 03 B 41/00

(54) Verfahren zum Ausrichten und Prüfen eines mit Mustern versehenen Werkstücks, z.B. einer Maske für die Herstellung von Halbleiterelementen.

(30) Priorität: 19.12.80 US 218322
19.12.80 US 218323

(43) Veröffentlichungstag der Anmeldung:
30.06.82 Patentblatt 82/26

(45) Bekanntmachung des Hinweises auf die Patenterteilung:
05.02.86 Patentblatt 86/6

(84) Benannte Vertragsstaaten:
DE FR GB

(56) Entgegenhaltungen:
FR - A - 2 439 437
US - A - 3 901 814
US - A - 4 264 822

IEEE TRANSACTIONS ON ELECTRON DEVICES, Band
ED-27, Heft 8, August 1980, NEW YORK (US) YASUO
TARUI: "Basic Technology for VLSI (Part II)", Seiten
1321-1331
IBM TECHNICAL DISCLOSURE BULLETIN, Band II, Heft
12, Mai 1969, NEW YORK (US) R.F. TYNAN: "Integrated
circuit mask inspection technique", Seiten 1695-1696

(73) Patentinhaber: International Business Machines
Corporation, Old Orchard Road, Armonk, N.Y. 10504 (US)

(72) Erfinder: Benjamin, Charles Ephraim, 12 Kingwood
Drive, Poughkeepsie N.Y. 12601 (US)
Erfinder: Crawford, David James, 50 Ziegler Avenue,
Poughkeepsie N.Y. 12603 (US)
Erfinder: Davis, Donald Eugene, 129 Edge Hill Drive,
Wappingers Falls N.Y. 12590 (US)
Erfinder: Moore, Richard David, East Hook Road,
Hopewell Junction N.Y. 12533 (US)
Erfinder: Ryan, Philip Meade, R. D. No. 3 Ladue Road
Box 377, Hopewell Junction N.Y. 12533 (US)
Erfinder: Weber, Edward Victor, 60 Round Hill,
Poughkeepsie N.Y. 12603 (US)

(74) Vertreter: Willich, Wolfgang, Dipl.-Ing., Schönaicher
Strasse 220, D-7030 Böblingen (DE)

# 0 054 710

**Beschreibung**

Automatische Verfahren zum Ausrichten von mit Mustern versehenen Werkstücken, wie insbesondere Masken, und zu deren Prüfung auf Fehlerstellen haben eine große wirtschaftliche Bedeutung. Die bisher angewendeten Methoden sind technisch und wirtschaftlich unbefriedigend. Denn Ausrichtung und Prüfung der Masken werden vielfach noch manuell mittels Mikroskop durchgeführt, wobei die Position der Maske von Hand justiert werden muß und eine große Erfahrung im Erkennen und Messen unterschiedlicher Arten geometrischer Fehler anhand von statistischen Musterfällen gefordert wird, mit dem Ergebnis, daß auf diese Weise keine vollständige Prüfung der Masken möglich ist.

Versuche zur Automatisierung der Prüfung derartiger Werkstücke sind bisher nicht sehr erfolgreich gewesen, und zwar hauptsächlich deshalb, weil Ungenauigkeiten in der Positionierung zwischen den einzelnen Bereichen zu Fehldeutungen von Fehlerstellen führten, wobei schon bei der Maskenherstellung auftretende Ungenauigkeiten von maßgeblichem Einfluß sind. Gerade solche Ungenauigkeiten und Abweichungen wurden bisher häufig nicht berücksichtigt, was insbesondere bei sehr komplexen Maskenmustern problematisch ist.

Verfahren und Anordnungen zur Herstellung von Halblei- ter-Werkstückmustern mittels Elektronenstrahl sind in den US-A- 3 866 013 und 3 875 416 beschrieben, jedoch befassen sich die dort erläuterten Maßnahmen nicht mit der Prüfung von Photomasken und ähnlichen Werkstücken. Weiterhin ist im IBM Technical Disclosure Bulletin, Bd. 11, Nr. 12, Seiten 1695 und 1696 eine Maskenprüfanordnung mit Kathodenstrahl beschrieben, bei der die zu prüfende Maske über ein optisches System Punkt für Punkt mit einer Mustermaske verglichen wird.

Der Erfindung liegt die Aufgabe zugrunde, die oben aufgezeigten Mängel der bisher üblichen Methoden zur Ausrichtung und Prüfung mit Mustern versehener Werkstücke zu vermeiden und ein Verfahren aufzuzeigen, das unter Heranziehen der zu der Herstellung des Werkstücks und der darauf befindlichen Muster verwendeten Daten ein selbständiges genaues Ausrichten und Prüfen des Werkstücks gewährleistet und das sich insbesondere auch für Masken mit sehr feinen und komplexen Musterstrukturen eignet. Zur Lösung dieser Aufgabe verwendet die Erfindung in bekannter Weise einen steuerbaren Abtaststrahl und eine Auswerteschaltung für die von der Werkstückoberfläche reflektierten bzw. transmittierten Signale, z. B. Sekundärelektronen, wobei der Abtaststrahl bereits zum Ausrichten auf einander folgend auf unterschiedliche Bereiche des zu prüfenden Werkstücks abgelenkt wird.

Die Erfindung ist durch das in den Patentansprüchen beschriebene Verfahren gekennzeichnet. Gemäß der Erfindung werden, ungeachtet eventuell vorhandener Grobausrichtmarken für eine vorherige Grobausrichtung des Werkstücks, bestehende geometrische Figuren, wie Kanten oder dgl., von ausgewählten Bereichen des Maskenmusters, deren Lage zueinander durch die Daten von der Herstellung des Musters bekännt ist, als maschinell abtastbare Feinausrichtmarken benutzt, so daß jedes Feld und jeder Bereich eines Feldes in Bezug auf die jeweilige Prüfposition genau lokalisiert und gemessen werden kann. Hierbei spielt es keine Rolle, ob einzelne Musterbereiche einheitlich oder untereinander unterschiedlich sind, und eventuelle Herstellfehler oder Probleme bei der exakten Einhaltung der Vorschubschritte bleiben ohne Einfluß auf das Ausricht- und Prüfergebnis. Denn es werden die digital gespeicherten Daten des Herstellprozesses des betreffenden Werkstücks verwendet. Die Anwendung des erfindungsgemäßen Verfahrens gewährleistet daher eine kostengünstige hundertprozentige Prüfung auch von Werkstücken mit komplexer geometrischer Musterstruktur feinster Rasterung. So können Fehlerstellen von einer Größe von 1 Durchmesser sicher festgestellt werden, wenn der Elektronenstrahl eine quadratische Fläche mit einer Seitenlänge von etwa 1,5 erfaßt, so daß er die jeweils vorherige Abtastfläche um 0,75 bis 1 in jeder Achsenrichtung überlappt. Die Verwendung einer Strahlfläche, die etwa der Mindestfläche der festzustellenden Fehlerstellen entspricht, verbessert die Leistung des Systems und vermeidet aufwendige Mustererkennungseinrichtungen und -programme, wie sie bei kleineren Strahlflächen notwendig sind.

Ein besonderer Vorteil des erfindungsgemäßen Verfahrens ist, daß die Position festgestellter Fehler ohne weitere Analyse sogleich zur Verfügung steht und registriert werden kann, da die Adressierung und Abtastung der einzelnen Bereiche in Übereinstimmung mit der vorliegenden Beschreibung erfolgt. Zur Durchführung des erfindungsgemäßen Verfahrens kann ein Elektronenstrahl, ein Kathodenstrahl oder ein optischer Strahl im sichtbaren oder unsichtbaren Bereich verwendet werden, wie etwa Infrarotlicht oder Röntgenstrahlen. Weiterhin ist es möglich, Masken aus strahldurchlässigem oder aus reflektierendem Material zu prüfen, und die verwendete Strahlart braucht nicht die gleiche zu sein wie die beim Einsatz der Maske zur Musterherstellung verwendete.

Das erfindungsgemäße Verfahren wird im folgenden anhand der Zeichnungen in mehreren Varianten erläutert. Es zeigen:

Fig. 1 in schematischer Darstellung eine Anordnung zur Durchführung des erfindungsgemäßen Verfahrens zum Ausrichten und Prüfen von mit Mustern versehenen Werkstücken,

Fig. 2 eine Gesamtansicht eines zu prüfenden Werkstücks in Draufsicht,

Fig. 3 in vergrößerter Darstellung ein bestimmtes Feld des Werkstücks gemäß Fig. 2,

Fig. 4 ein schematisches Schaltbild der in der Anordnung nach Fig. 1 verwendeten Bemessungsschaltung,

Fig. 5 ein schematisches Schaltbild der in der Anordnung nach Fig. 1 verwendeten Schwellwertschaltung,

Fig. 6 einen Teilbereich des in Fig. 3 dargestellten Feldes in der Verwendung für das Ausrichten,

Fig. 7 den Teilbereich gemäß Fig. 6 mit Darstellung der bei der Fehlerprüfung verwendeten Randbereiche an den Grenzen der Muster- und der ungemusterten Flächen,

Fig. 8 ein Diagramm mit den Eingangs- und Ausgangssignalen der Bemessungsschaltung gemäß Fig. 4

2

0 054 710

während eines Abtastvorganges,

Fig. 9 ein Diagramm entsprechend der Fig. 8, jedoch für die Abtastung eines Musters gemäß Fig. 10 und

Fig. 10 die Darstellung eines Musters mit verschobenen, asymmetrischen Abtastbereichen.

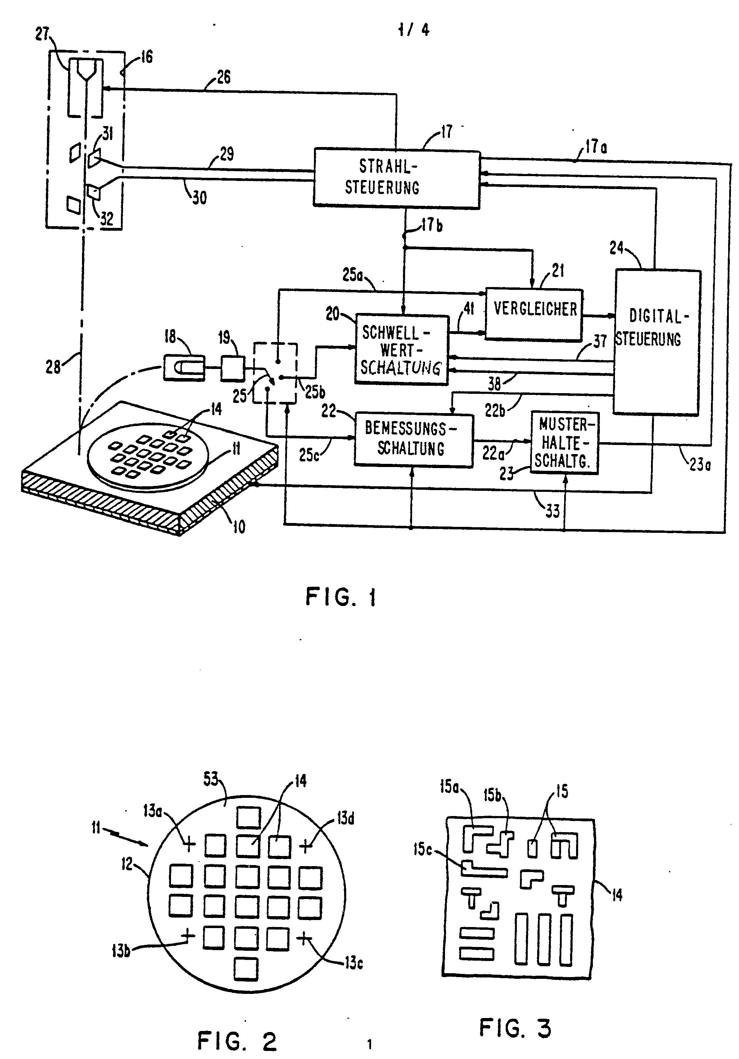

Die in Fig. 1 dargestellte Anordnung enthält einen in X- und Y-Richtung verstellbaren Tisch 10, auf dem das zu prüfende Werkstück 11, z.B. eine Maske, aufliegt. Das Werkstück 11 besteht, wie Fig. 2 zeigt, aus einem Substrat 12 mit einer Anzahl Grob-Richtmarken 13a, 13b, 13c und 13d sowie einer Anzahl Felder 14. Die Grob-Richtmarken 13 sind als Kreuze ausgebildet, können aber auch in Form eines Winkels usw. dargestellt sein.

Als Werkstücke kommen im vorliegenden Zusammenhang auch als Chipträger verwendete gemusterte Substrate in Betracht oder optisch durchlässige Masken aus Glas mit einer Schicht optisch undurchlässiger Materialien, wie Metall oder Photoresist. Andererseits können die Masken auch aus anderen Materialien, wie z.B. Silicon, bestehen, die für infrarotes Licht durchlässig sind. Im vorliegenden Beispiel wird ein Substrat 12 aus Glas zugrundegelegt, dessen Muster 15 durch auf das Glas aufgetragene dünne Metallfilme gebildet ist.

Jedes Feld besteht, wie Fig. 3 zeigt, aus einer Anzahl unterschiedlicher geometrischer metallisierter Muster 15, die, wie erwähnt, auf das Substrat 12 aufgetragen sind. Üblicherweise, wenn auch nicht in jedem Fall, sind die Felder 14 untereinander identisch. Die nachfolgend beschriebene Ausrichtung und Prüfung der einzelnen Felder setzt dies jedoch nicht voraus. Jede zu prüfende Maske kann daher eine Vielzahl unterschiedlicher Muster einschließlich der Steuertestmuster aufweisen.

Die Anordnung gemäß Fig. 1 enthält weiterhin ein Elektronenstrahlgerät 16, eine Strahlsteuerung 17, einen Detektor 18, einen Verstärker 19, eine Schwellwertschaltung 20, einen Vergleicher 21, eine Bemessungsschaltung 22, eine Muster-Halte-Schaltung 23, eine Digitalsteuerung 24 sowie einen Schalter 25 zum Verbinden des Detektors 18 und des Verstärkers 19 entweder mit dem Vergleicher 21, der Schwellwertschaltung 20 oder der Bemessungsschaltung 22. Dabei ist die Betätigung des Schalters 25 mittels einer Leitung 17a mit den Operationen der Strahlsteuerung 17 synchronisiert. Die Digitalsteuerung 24 ist als Universalrechner (Prozessor) ausgebildet und enthält alle erforderlichen Informationen und Daten bezüglich der zu prüfenden Maske einschließlich aller Richtmarken sowie der Form und Position der einzelnen Muster 15. Weiterhin erzeugt die Digitalsteuerung 24 die Signale zum Betrieb der Strahlsteuerung 17, die über eine Leitung 26 die Elektronenstrahlquelle 27 zur Erzeugung des Elektronenstrahls 28 ein- und ausschaltet. Die Strahlsteuerung 17 steuert weiterhin über die Leitungen 29 und 30 in bekannter Weise die Ablenkplatten 31 und 32 für den Elektronenstrahl 28 und synchronisiert über die Leitungen 17a und 17b die Operationen der Schwellwertschaltung 20, des Vergleichers 21, der Bemessungsschaltung 22 und der Muster-Halte-Schaltung 23 sowie des Schalters 25. Schließlich steuert die Digitalsteue: rung 24 über eine Leitung 33 auch die jeweilige Position des Tisches 10.

Die zu prüfende Maske wird auf dem Tisch 10 durch eine entsprechende Spannvorrichtung, beispielsweise mittels Vakuum, festgehalten. Bei der dargestellten Ausführung ist auf der Oberfläche des Substrats 12 eine dünne, leitende, geerdete transparente Schicht 53 aufgebracht, wodurch sichergestellt ist, daß der Elektronenstrahl weder das die Muster 15a, 15b usw. bildende Material noch das Substrat selbst auflädt, während er über die ausgewählten Bereiche geführt wird. Ein geeignetes Material hierfür ist beispielsweise Zinnoxid. Die Schicht 53 (Fig. 2) ist jedoch nicht erforderlich, wenn das Substrat leitend oder halbleitend ist, oder wenn es sich um einen Strahl ohne Aufladungseffekt handelt, wie z.B. einen Lichtstrahl.

Zunächst wird der Schalter 25 so eingestellt, daß der Detektor 18 und der Verstärker 19 über die Leitung 25b mit der Schwellwertschaltung 20 verbunden werden sowie die als Prozessor wirksame Digitalsteuerung 24 die Strahlsteuerung 17 zum Einschalten des Elektronenstrahls 28 veranlaßt, der die Maske 11 mit ihren Feldern 14 zu erfassen vermag. Das Auftreffen des Elektronenstrahls auf dem Glas des Substrats 12 und den unterschiedlichen Mustern 15 auf dem Substrat 12 verursacht sowohl Sekundärelektronen als auch von der Maske reflektierte rückstreuende Elektronen. Jedes der Materialien, wie z.B. Glas oder das die Muster bildende Material, emittiert unterschiedliche Stärken von Sekundärelektronen und rückstreuenden Elektronen.

Aus dem vorgenannten Grund wird das Glas des Substrats 12 Sekundärelektronen von einer bestimmten, üblicherweise geringen Stärke emittieren, während die Muster Sekundärelektronen von hiervon abweichender, vorzugsweise höherer Stärke emittieren. Zur Vereinfachung wird daher im folgenden bei den beschriebenen Vorgängen die Ermittlung der jeweiligen Sekundärelektronen zugrundegelegt, obwohl die dargestellte Anordnung genauso rückstreuende Elektronen verwenden könnte.

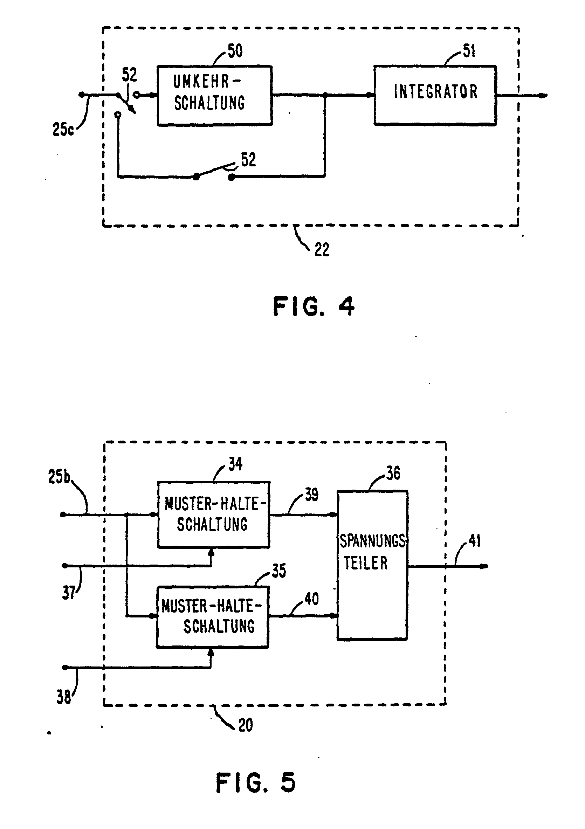

Der Elektronenstrahl wird nun zum Abtasten über ein ausgewähltes Feld 14 gesteuert. Hierbei entstehen unterschiedliche Stärken von Sekundärelektronen, je nachdem, ob der Strahl auf eine Glas- oder eine Musterfläche auftrifft. Diese Sekundärelektronen werden durch den Detektor 18 festgestellt, der ein entsprechendes Signal proportional zur jeweiligen Zahl der Sekundärelektronen erzeugt, welches durch den Verstärker 19 verstärkt und anschließend zur Schwellwertschaltung 20 übertragen wird. Die Schwellwertschaltung 20 enthält, wie Fig. 5 zeigt, ein Paar von Muster-Halte-Schaltungen 34 und 35 sowie einen Spannungsteiler 36.

Der Elektronenstrahl wird zunächst auf die Glasfläche des Substrats 12 gerichtet, und gleichzeitig sendet die Digitalsteuerung 24 über eine Leitung 37 ein Signal zur Muster-Halte-Schaltung 34 zu deren Einschaltung, und dieses Signal endet nach einer vorbestimmten Zeit. Sodann wird der Elektronenstrahl auf eine Musterfläche gerichtet, und ein zweites Signal gelangt über eine Leitung 38 zur Muster-Halte-Schaltung 35. Diese Maßnahmen dienen zur Bemessung des Schwellwerts in der Schaltung 20 für ein bestimmtes Feld der Maske.

Die Ausgangssignale der Muster-Halte-Schaltungen 34 und 35 gelangen über Leitungen 39 bzw. 40 zum Spannungsteiler 36, dessen Ausgangssignale über eine Leitung 41 dem Vergleicher 21 zugeführt werden und der

3

eine Schwellwertspannung gegen die auf der Leitung 25a dem Vergleicher 21 zugeführten Signale liefert. Dieser Schwellwert ist daher dynamisch und wird durch den Durchschnittswert der unterschiedlichen Signalstärken bestimmt, wie sie bei der Abtastung der Sekundärelektronen von den Glasflächen und den Musterflächen entstehen. Diese Bestimmung eines Schwellwerts für die Signalstärke ist insbesondere von Wichtigkeit, wenn das aufgrund der Sekundärelektronen ermittelte Signal unruhig oder uneinheitlich ist, nämlich infolge von Dichteänderungen, geometrischen Fehlern oder ähnlichem schwankt. Für bestimmte Anwendungen kann man auch mehr als einen Schwellwert verwenden. Auch kann man den Schwellwert periodisch an wechselnde Strahlströme oder Signalstärken anpassen, wie sie durch unterschiedliche bestrahlte Objekte, wie Musterdicke oder -dichte verursacht sein können.

Die Anordnung gemäß Fig. 1 kann, wenn erwünscht, mit einem optischen Mikroskop ausgerüstet werden, um das Werkstück 11 mittels visueller Beobachtung der Richtmarken 13a, 13b, 13c und 13d grob auszurichten. Im Anschluß daran wird die in der Digitalsteuerung 24 gespeicherte Information zur Einschaltung des Elektronenstrahlgeräts 16 und zur Steuerung der Bewegung des Tisches 10 eingesetzt. Hierbei wird das Werkstück, im folgenden als Maske 11 bezeichnet, um einen festgelegten Betrag und in eine vorgegebene Richtung bewegt, so daß der Strahl nun auf ein ausgewähltes Feld 14 gerichtet ist. Nun bewirkt die Strahlsteuerung 17, daß der Strahl 28 das ausgewählte Feld 14 bzw. einen bestimmten Bereich desselben überstreicht.

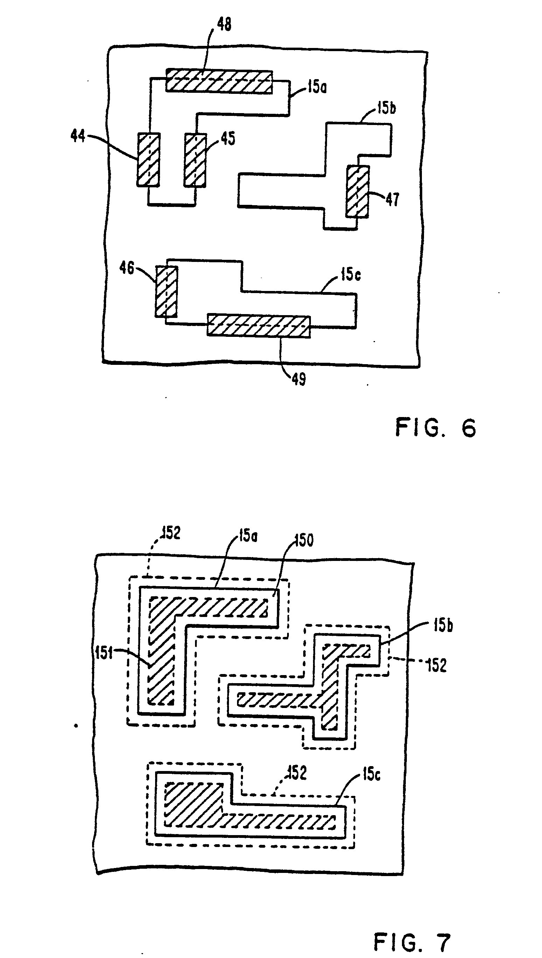

Die genaue Registrierung jedes Feldes bis zu einer endgültigen vorbestimmten Prüfposition erhält man nun durch Abtasten bestimmter Muster 15 eines Bereichs oder Teilbereichs des ausgewählten Feldes 14. Dabei kann der ausgewählte Bereich ausschließlich zum Zweck des Ausrichtens und von Feld zu Feld gleich gestaltet sein, oder er ist ein Bestandteil des Feldmusters selbst, in welchem Fall das Muster von Feld zu Feld unterschiedlich sein kann. Die zum Zwecke der Registrierung abzutastenden Muster werden in der gleichen Weise vorbestimmt wie die entsprechenden Muster, die zur Durchführung der Prüfung benützt werden, wobei irgendein ausgewählter Bereich des Feldes verwendet werden kann. Ein Beispiel hierfür zeigt Fig. 6, wo drei im oberen linken Eckbereich des Feldes 14 angeordnete Musterbereiche gemäß Fig. 3 vergrößert dargestellt sind und als ausgewählter Bereich dieses Feldes im nachfolgenden Beispiel verwendet werden.

Es wird nun der Schalter 25 so eingestellt, daß die Bemessungsschaltung 22 über die Leitung 25c mit dem Detektor 18 und dem Verstärker 19 verbunden wird. Die Digitalsteuerung 24 bewirkt nun über die Strahlsteuerung 17 die Steuerung des Elektronenstrahls 28 derart, daß dieser ausgewählte Kanten jedes der Muster 15a, 15b und 15c abtastet und hierbei deren Lage relativ zu der gewünschten Prüfposition ermittelt. Ist die tatsächliche Position dieser ausgewählten Muster bestimmt, bewirkt die Bemessungsschaltung 22 über die Muster-Halte-Schaltung 23 und die Leitung 23a eine Positionskorrektur in der Strahlsteuerung 17, in deren Folge der Elektronenstrahl 28 in eine solche Lage gelenkt wird, daß in bezug auf den Bewegungsbereich des Strahls das gesamte ausgewählte Feld in die gewünschte Prüfposition gelangt.

Läßt man den Strahl einen eine Kante des Muster überlappenden Bereich überstreichen und integriert das Signal, das hierbei längs der Kante des Musters entsteht, und kehrt man sodann die Signalpolarität um, so daß der Strahl eine entsprechende Länge der entgegengesetzten Kante des Musters überstreicht, und integriert man sodann dieses Signal und summiert die Integrationssignale auf, so erhält man einen Fehlerbetrag, der die Abweichung des Musterbildes von der gewünschten Prüfposition anzeigt, in die der ausgewählte Bereich des Feldes auszurichten ist. Dieser Fehlerbetrag ist unabhängig von eventuellen Größenfehlerwerten. In der beschriebenen Weise wird beispielsweise der Strahl zunächst auf die linke Kante, also in horizontaler Richtung über das Muster 15 geführt, die in Fig. 6 durch die schraffierte Fläche des Bereichs 44 dargestellt ist. Dieser Abtastvorgang erzeugt Sekundärelektronen sowohl vom Muster als auch von der Substratglasoberfläche, die vom Detektor 18 erkannt und der Bemessungsschaltung 22 zugeführt werden.

Wie Fig. 4 zeigt, enthält die Bemessungsschaltung 22 eine Umkehrschaltung 50, eine Integrationsschaltung 51 und einen Schalter 52, der über die Leitung 22b von der Digitalsteuerung 24 betätigt wird. Durch Schließen des Schalters 52 wird die Umkehrschaltung 50 von der Bemessungsschaltung 52 getrennt.

Vor dem Abtasten des Bereichs 44 wird der Schalter 52 geöffnet, so daß das Signal durch die Umkehrschaltung 50 hindurchgelangt. Der Elektronenstrahl wird nun längs der Kante des Musters 15a bewegt. Die hierbei überstrichene Fläche habe eine bestimmte Breite B und Länge L und ist als den Bereich 44 darstellende schraffierte Fläche gezeichnet. Das hierbei abgetastete Signal wird vom Detektor 18 über die Leitung 25c zur Bemessungsschaltung 22 geleitet, die Umkehrschaltung kehrt das Eingangssignal um und führt es dem Integrator 51 zu, dessen Ausgangssignal auf Leitung 22a der Muster-Halte-Schaltung 23 zugeführt wird.

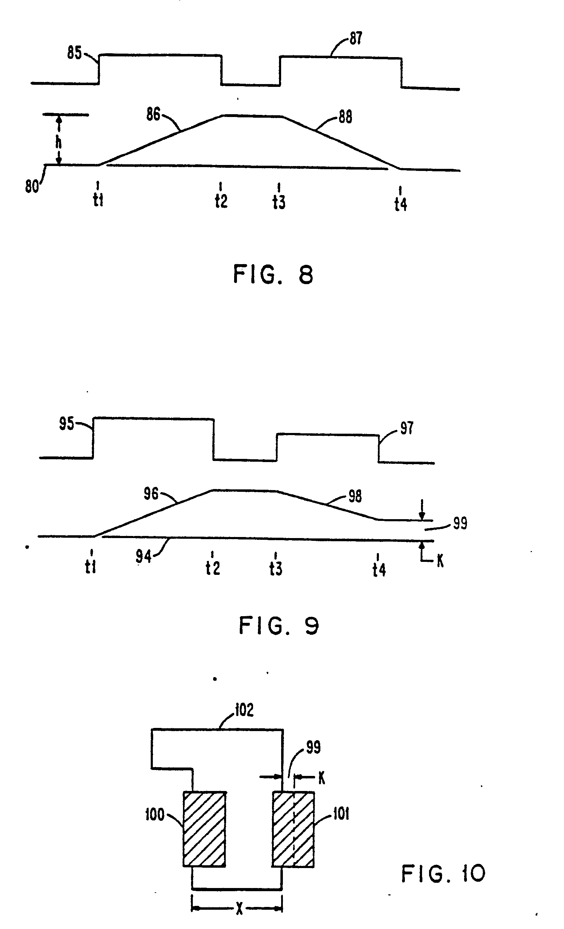

Wie Fig. 8 zeigt, erzeugt der Detektor 18 zur Übertragung über die Leitung 25c einen Rechteckspannungsimpuls 85 von der Zeit tl bis zur Zeit t2. Dieser Rechteckspannungsimpuls wird mittels der Bemessungsschaltung 22 in eine Spannungslinie mit zunehmendem Spannungswert umgewandelt, und dieses Signal erscheint auf Leitung 22a. Es beginnt zur Zeit tl und wird kontinuierlich über einen Grundwert 80 (vgl. Fig. 8) erhöht, bis der Rechteckspannungsimpuls 85 zur Zeit t2 endet. Die Höhe h, um die die Spannungslinie 86 ansteigt, ist proportional zur Gesamtzahl der Sekundärelektronen, die von dem abgetasteten Bereich 44 emittiert werden. Ein Prozentsatz der Sekundärelektronen, die vom Detektor 18 festgestellt werden, stammt von der Substratglasoberfläche und der Rest von der Musteroberfläche.

Nach vollständiger Abtastung des Bereichs 44 wird der Elektronenstrahl 28 abgeschaltet, und die Bemessungsschaltung 22 wird durch Umschalten des Schalters 52 zurückgestellt. Nun wird der Strahl um einen der Breite des Musters 15a entsprechenden Betrag nach rechts geschwenkt, so daß nun der Bereich 45 längs der rechten Kante des Musters 15 überstrichen werden kann. Dieser Bereich 45 hat gleichfalls die Breite B und die Länge L. Bei der Abtastung dieses Bereichs werden in gleicher Weise die Sekundärelektronen durch den Detektor 18 registriert und von der Zeit t3 bis zur Zeit t4 als Rechteckspannungsimpuls 87 über die Leitung 25c zur Bemessungsschaltung 22 übertragen. Da jedoch in diesem Fall der Schalter 25 in der Stellung ist, in welcher die Umkehrschaltung 50 ausgeschaltet ist, wird dieses Signal unter Umgehung der Umkehrschaltung 50 unmittelbar dem Integrator 51 zugeführt. Das Ausgangssignal der Bemessungsschaltung 22 ist durch die Spannungslinie 88 mit abnehmendem Spannungswert charakterisiert. Wenn diese Spannungslinie, wie dargestellt, zur Zeit t4 den Grundwert 80 erreicht, zeigt dies, daß der Bereich 44 genau den gleichen Betrag des Musters 15a überlappt wie der Bereich 45.

Wenn die Abtastung nicht genau die gleichen Beträge für den Musterbereich und die Substratglasoberfläche der Schicht 53 ergibt, erhält man unterschiedliche Höhenwerte für die Spannungslinie 86 mit zunehmendem Spannungswert einerseits und die Spannungslinie 88 mit abnehmendem Spannungswert andererseits mit der Folge, daß die Spannungslinie 88 nicht bis auf den Grundwert 80 zurückkehrt. In diesem Fall kann der Differenzwert als Anzeige für den Korrekturwert gewertet werden, der zur Erreichung der gewünschten Prüfposition zu berücksichtigen ist. Dieser Fall wird im folgenden anhand der Fign. 9 und 10 erläutert.

In Fig. 10 sind das Muster 102 überlappende Abtastbereiche 100 und 101 gezeigt, wobei der Abtastbereich 100 das Muster 102 um einen größeren Betrag überschneidet als der Abtastbereich 101. Gemäß Fig. 9 ergibt die Abtastung des Bereichs 100 einen Rechteckspannungsimpuls von der Zeit tl bis zur Zeit t2, welcher mittels der Bemessungsschaltung 22 in einer Spannungslinie 96 mit zunehmendem Spannungswert umgewandelt wird, beginnend am Grundwert 94. Da der Abtastbereich 100 eine größere Fläche des Musters 102 überdeckt, ist die Zahl der festgestellten Sekundärelektronen entsprechend höher.

Der Elektronenstrahl überstreicht nun anschließend den Abtastbereich 101, und in der Folge des geringeren Überlappungsbereich desselben ist der Rechteckspannungsimpuls 97 im Zeitintervall von t3 bis t4 von geringerer Höhe als der Rechteckspannungsimpuls 95. Infolgedessen erreicht die daraus resultierende Spannungslinie 98 mit abnehmendem Spannungswert nicht den Grundwert 94, sondern endet in einer mit 99 bezeichneten Höhe oberhalb des Grundwerts 94. Dieser Wert ist proportional zur Abweichung K der Kante des Musters 102 von der Zentrallinie der Abtaststrahlen, und dieser Abweichungswert wird nun über die Leitung 23a zur Strahlsteuerung 17 übertragen, um die Strahlrichtung entsprechend zu korrigieren. Wenn gewünscht, kann die erhaltene Information gleichzeitig zur Digitalsteuerung 24 übermittelt werden, die ihrerseits entsprechende Steuersignale zur Strahlsteuerung 17 sendet.

Überstreicht man mit dem Elektronenstrahl zunächst die rechte und dann die linke Kante des Musters 15a und integriert man sodann die in beiden Fällen ermittelte Zahl der abgetasteten Sekundärelektronen, so kann die Position der Abtaststrahlen in bezug auf das Muster in der Richtung von links nach rechts bestimmt werden. Wenn gewünscht, kann dieses Verfahren unter Zugrundelegung eines anderen linken Bereichs 46 des Musters 15c und eines rechten Bereichs 47 des Musters 15b wiederholt werden. Ist der betreffende Bereich, als Teil des gesamten Feldes, in der Richtung von links nach rechts, also in horizontaler Richtung in die gewünschte Position justiert worden, so wird das gleiche Verfahren in bezug auf die Richtung von oben nach unten, also in vertikaler Richtung wiederholt. Hierzu wird der Elektronenstrahl zunächst über den Bereich 48 im oberen Teil des Musters 15a geführt und dann über den Bereich 49 im unteren Teil des Musters 15c, wie in Fig. 6 dargestellt. Auch in diesem Fall handelt es sich um Flächen mit gleicher Breite und Länge, so daß die resultierenden Signale proportional zum Betrag der Überlappung von Strahl und Mustern sind. Die hierbei ermittelte Information wird nun wiederum der Strahlsteuerung 17 zugeführt, um eine entsprechende Korrektur in der Vertikalrichtung zur Erreichung der gewünschten Prüfposition auszuführen.

Nach Durchführung dieser Feldregistrierung kann nun das gesamte Feld geprüft werden. Hierzu wird zunächst der Schalter 25 zurückgeschaltet, so daß die Bemessungsschaltung 22 abgeschaltet und der Vergleicher 21 an den Detektor 18 und den Verstärker 19 angeschlossen wird. Nun wird ein Spannungswert entsprechend dem zuvor ermittelten Schwellwert von der Schwellwertschaltung 20 über die Leitung 41 dem Vergleicher 21 zugeführt. Die Digitalsteuerung 24, in der alle Daten über die zu prüfenden Muster enthalten sind, veranlaßt das Einschalten des Elektronenstrahls 28 zur Abtastung der Muster 15a, 15b und 15c innerhalb des zu prüfenden Bereichs. Hierbei ist der Strahl von einheitlicher Größe und wandert nur über diejenigen Flächen der Bereiche, in denen sich Muster befinden. Der Vergleicher 21 liefert für den jeweiligen Sekundärelektronenstrom von jedem abgetasteten Muster ein Signal zur Digitalsteuerung 24, sooft das Abtastsignal unter die Schwellwertspannung abfällt, wobei die entsprechenden Koordinaten des Strahls zur Anzeige 'fehlendes Muster' an dieser Stelle registriert werden. Wenn jedes der Muster 15a, 15b und 15c abgetastet ist, wird der Strahl schrittweise weitergeschaltet über diejenigen Bereiche, wo keine Muster oder musterartige Materialien zu erwarten sind. Auch hierbei wird der Sekundärelektronenstrom gemessen und der Digitalsteuerung 24 immer dann ein Signal zugeführt, wenn der Strom den festgelegten Schwellwert überschreitet. In diesem Fall werden die entsprechenden Koordinatenwerte des Strahls gleichfalls registriert, zur Anzeige, daß an dieser Stelle ein Muster oder ein musterähnliches Material festgestellt wurde, obwohl hier keines erwartet worden ist.

Wie in Fig. 7 dargestellt, ist es erwünscht, daß ein schmaler Randbereich um die Muster 15a, 15b und 15c herum bei der Abtastung durch den Elektronenstrahl ausgespart wird. Dieser Randbereich 150 ist in Fig. 7 durch die gestrichelten Linien 151 und 152 (Muster 15a) dargestellt. Demgemäß erfolgt die Abtastung des Musters 15a über dem Bereich der schraffierten Fläche innerhalb der gestrichelten Linie 151 und die Abtastung der umgebenden Bereiche außerhalb der gestrichelten Linie 152. Entsprechendes gilt für die Muster 15b und 15c. Selbstverständlich ist, wenn man auf diese Randbereiche 150 verzichtet, der Schaltungs- und Programmspeicheraufwand erheblich gering.

Jeder einen Teilbereich eines Feldes bildende Bereich wird aufeinanderfolgend dreimal abgetastet: Das erste Mal mit einer Ablenkung über die Kanten der erwarteten Muster in dem betreffenden Bereich, um die Lage des betreffenden Bereichs unmittelbar zu registrieren; das zweite Mal mit einer Ablenkung über alle Teile des betreffenden Bereichs, von denen eine bestimmte Signalstärke erwartet wird, und das dritte Mal mit einer Ablenkung des Strahls über alle anderen Teile des Bereichs, von denen die andere Signalstärke erwartet wird. Die beiden letzten Abtastvorgänge sind daher im wesentlichen komplementär innerhalb eines Bereichs, jedoch von einem Bereich zum nächsten unterschiedlich. Alle drei Abtastvorgänge sind jeweils durch die vorliegende gespeicherte Information über die bestehenden Muster auf dem zu prüfenden Werkstück definiert, wobei üblicherweise die numerischen Datentafeln verwendet werden, die bereits zur Herstellung des Werkstücks dienten.

Das Abtasten der zuvor beschriebenen komplementären Bereiche wird zweckmäßig durch die Abtastung aufeinanderfolgender einzelner Rechteckbereiche durchgeführt, mit vorgegebenen Koordinaten für jede Strahlposition, so daß bei Abweichung von einem erwarteten Reflexionssignal die Koordinaten der betreffenden Fehlerposition unmittelbar zur Verfügung stehen und für eine nachfolgende Reparatur registriert werden können. Die Anwendung von rechteckigen oder quadratischen, nicht überlappenden Strahlbereichen ist bekannt. Die Verwendung relativ großer überlappender rechteckiger Strahlbereiche hat demgegenüber die Vorteile eines höheren Durchsatzes, höherer Sicherheit in der Feststellung signifikanter Fehlstellen, geringere Wahrscheinlichkeit der irrtümlichen Identifizierung von Fehlstellen sowie ausreichender Signalstärke.

## Patentansprüche

1. Verfahren zum Ausrichten und Prüfen eines mit Mustern versehenen Werkstücks, z.B. einer Maske für die Herstellung von Halbleiterelementen, mittels eines Abtaststrahles, der für die Muster und für die sonstigen Werkstückoberflächen unterschiedliche Signale erzeugt, mit einem Ablenksystem, das an eine von einem Rechner überwachte Steuerschaltung angeschlossen ist, und mit einer Auswerteschaltung für die abgetasteten Signale, dadurch gekennzeichnet,
daß der Abtaststrahl über den Bereich einer ersten Kante eines ausgewählten Musters bewegt und die dabei gewonnene Signalinformation gespeichert wird, daß der Abtaststrahl sodann über den Bereich einer im wesentlichen parallel zur ersten Kante verlaufenden zweiten Kante dieses Musters bewegt und die dabei gewonnene Signalinformation gleichfalls gespeichert wird, wobei der Bereich jeweils durch eine Rechteckfläche bestimmt ist, die sowohl das Mustermaterial als auch den dazu benachbarten Teil überdeckt und deren lange Kanten sich parallel zu der ersten und zweiten Kante des Musters erstrecken, und wobei die Bereiche jeweils gleiche Abmessungen aufweisen,
daß sodann zur Auswertung der vom Abtaststrahl erzeugten, gespeicherten Signalinformation die beim Abtasten des jeweils ersten Bereiches gewonnene Signalinformation umgekehrt und sodann integriert wird und die beim Abtasten des zweiten Bereiches gewonnene Signalinformation ohne Umkehrung integriert wird,
daß das der Abweichung der Musterkante von der Zentrallinie des Abtaststrahls proportionale Summensignal der beiden Integrale dem Eingang der Strahlsteuerungsschaltung zugeleitet wird, wodurch die Strahlposition in bezug auf das Muster entsprechend korrigiert wird,
daß das Werkstück mit den gemessenen ersten und zweiten Kanten in eine vorgegebene Prüfposition bewegt wird, und daß sodann der Abtaststrahl zur Prüfung über das gesamte Muster und ggf. weitere Muster auf dem Werkstück bewegt wird.

2. Verfahren nach Anspruch 1,
dadurch gekennzeichnet,
daß der Abtaststrahl zusätzlich über den Bereich einer dritten Kante des ausgewählten Musters, die in einem vorbestimmten Winkel zur ersten und zweiten Kante verläuft, bewegt und die dabei gewonnene Signalinformation gespeichert wird,
daß der Abtaststrahl sodann über den Bereich einer vierten Kante dieses Werkstücks bewegt wird, die im wesentlichen parallel zur dritten Kante verläuft,
und daß unter Auswertung der so erhaltenen Signale das Werkstück mit den gemessenen dritten und vierten Kanten in eine vorgegebene Prüfposition bewegt wird.

3. Verfahren nach Anspruch 2, zum Ausrichten und Prüfen eines Werkstücks mit nicht, metallisierter Oberfläche und mit durch metallisierte Bereiche gebildeten Mustern, dadurch gekennzeichnet,
daß der Abtaststrahl als Elektronenstrahl auf eine metallisierte Musterfläche des Werkstücks gerichtet und der reflektierte und sekundäre Elektronenstrom gemessen wird,
daß der Abtaststrahl sodann auf einen nicht metallisierten Bereich des Werkstücks gerichtet und der reflektierte und sekundäre Elektronenstrom gemessen wird, daß daraus ein Schwellwert zwischen den beiden Strombereichen festgelegt wird,
daß der Strahl über den Bereich einer ersten Kante der metallisierten Fläche bewegt und der reflektierte und sekundäre Elektronenstrom gemessen wird, daß die Strahlrichtung um den Betrag der vorgegebenen Breite der metallisierten Fläche verändert und über den Bereich einer zweiten, zur ersten parallelen Kante der metallisierten Fläche bewegt und der reflektierte und sekundäre Elektronenstrom gemessen wird,
daß sodann durch Vergleich der gemessenen Werte die Differenz ermittelt wird,

daß die Strahlrichtung sodann um einen entsprechenden Betrag korrigiert wird,

daß der Strahl in gleicher Weise über die Bereiche einer dritten und vierten Kante, die in einem vorbestimmten Winkel zur ersten und zweiten Kante verlaufen, bewegt und durch Vergleich der gemessenen Werte die Differenz ermittelt wird,

daß die Strahlrichtung sodann um einen entsprechenden Betrag korrigiert wird,

daß der Strahl sodann über das gesamte Muster be- wegt und der reflektierte Elektronenstrom gemessen wird,

und daß dieser zur Fehlerermittlung mit dem festgelegten Schwellwert verglichen wird.

4. Verfahren nach Anspruch,3,
dadurch gekennzeichnet,

daß der Abtaststrahl auf einen ersten ausgewählten, eine ausgewählte erste Grob-Richtmarke enthaltenden Bereich gerichtet, die dabei gewonnene Signalinformation mit den Solldaten des Werkstücks verglichen und das Werkstück entsprechend dem Vergleichsergebnis in eine erste vorbestimmte Position ausgerichtet wird,

daß anschließend der Strahl über den gesamten ausgewählten ersten Bereich bewegt und die dabei gewonnene Signalinformation zur Fehlerermittlung im ersten Bereich mit den Solldaten des Werkstücks verglichen wird,

daß sodann der Abtatstrahl auf einen zweiten ausgewählten, eine ausgewählte zweite Grob-Richtmarke enthaltenden Bereich gerichtet, die dabei gewonnene Signalinformation mit den Solldaten des Werkstücks verglichen und das Werkstück entsprechend dem Vergleichsergebnis in eine zweite vorbestimmte Position ausgerichtet wird,

und daß anschließend der Strahl über den gesamten ausgewählten zweiten Bereich bewegt und die dabei gewonnene Signalinformation zur Fehlerermittlung im zweiten Bereich mit den Solldaten des Werkstücks verglichen wird.

5. Verfahren nach Anspruch 1 oder 2,
dadurch gekennzeichnet,
daß als Abtaststrahl ein Elektronenstrahl verwendet wird.

6. Verfahren nach einem der Ansprüche 1 bis 5,
dadurch gekennzeichnet,
daß als Abtaststrahl ein Kathodenstrahl verwendet wird.

7 . Verfahren nach den Anspruch 1 oder 2,
dadurch gekennzeichnet,
daß das Substrat aus Silicium besteht und der Abtaststrahl durch infrarotes Licht gebildet wird.

8 . Verfahren nach einem der Ansprüche 1 bis 6
dadurch gekennzeichnet,

daß das Werkstück als Substrat aus transparentem Werkstoff ausgebildet ist und das Muster als darauf aufgetragene, für den Abtaststrahl nicht transparente Filmschicht ausgebildet ist, derart, daß die Oberflächen von Werkstück und Muster unterschiedliche Reflektionswerte für den Strahl aufweisen.

## Claims

1. Method of positioning and inspecting a patterned workpiece, e.g. a mask for manufacturing semiconductor elements, by means of a scanning beam generating different signals for the patterns and for the other workpiece surfaces, with a deflector system connected to a computer-monitored control circuit, and with an evaluator circuit for the signals scanned,

characterized in that the scanning beam is moved over the region of a first edge of a selected pattern, and that the signal information obtained is stored,

that the scanning beam is then moved over the region of a second edge of this pattern extending substantially in parallel to the first edge, and that the thus obtained signal information is thus stored, the region being respectively determined by a rectangular surface which covers the pattern material as well as the portion adjacent thereto, and whose long edqes extend in parallel to the first and second edge of the pattern, the regions showing respectively the same dimensions,

that subsequently, for evaluating the stored signal information produced by the scanning beam the signal information obtained during the scanninq of the respective first region is inverted and subsequently integrated, and that the signal information obtained during the scanning of the second region is integrated without inversion,

that the sum signal of the two integrals which is proportional to the deviation of the pattern edge from the central line of the scanning beam is applied to the input of the beam control circuit, the beam position being correspondingly corrected with respect to the pattern, that the workpiece with the measured first and second edges is moved into a predetermined inspecting position, and that subsequently the scanning beam is moved for testing over the entire pattern and optionally over further patterns on the workpiece.

2. Method as claimed in claim 1, characterized in that the scanning beam is additionally moved over the region of a third edge of the selected pattern extending at a predetermined angle to the first and second edge, and that the signal information thus obtained is stored,

that the scanning beam is then moved over the region of a fourth edge of this workpiece which extends substantially in parallel to the third edge,

and that with the thus obtained signals being evaluated the workpiece with the measured third and fourth edges is moved into a predetermined inspecting position.

3. Method as claimed in claim 2, for aligning and inspecting a workpiece with a non-metallized surface and with patterns formed by metallized regions,

characterized in that the scanning beam as an electron beam is directed onto a metallized pattern surface of the workpiece, and that the reflected and secondary electron beam is measured,

that the scanning beam is then directed onto a non-metallized region of the workpiece and the reflected and secondary electron beam is measured, that a threshold value between the two current values is determined,

that the beam is moved over the region of a first edge of the metallized surface and the reflected and secondary electron beam is measured, that the beam direction is altered by the amount of the predetermined width of the metallized surface and moved over the region of a second edge of the metallized surface that is parallel to the first one, and that the reflected and secondary electron beam is measured,

that subsenuently the difference is determined by comparing the measured values, that the beam direction is then corrected by a correspondinq amount,

that the beam is similarly moved over the reqions of a third and fourth edge which extend at a predetermined anqle to the first and second edge, and that the difference is determined by comparing the values measured,

that the beam direction is then corrected by a correspondinq amount,

that the beam is subsequently moved over the en- tire pattern, and the reflected electron current is measured,

and that it is compared for error detection with the predetermined threshold value.

4. Method as claimed in claim 3,

characterized in that the scanninq beam is direct- ed onto a first region comprisinq a selected first gross alignment mark, that the siqnal information thus obtained is compared with the nominal data of the workpiece, and that the workpiece is aligned in a first predetermined position in accordance with the comparison result,

that subsequently the beam is moved over the entire selected first region, and the thus obtained signal information is compared for error detection in the first region with the nominal data of the workpiece,

that the scanning beam is then directed onto a second selected region comprising a selected second gross alignment mark, that the thus obtained signal information is compared with the nominal data of the workpiece, and that in accordance with the comparison result the workpiece is aligned in a second predetermined position,

and that subsequently the beam is moved over the entire selected second region, and the thus obtained signal information is compared for error detection in the second region with the nominal data of the workpiece.

5. Method as claimed in claim 1 or 2,

characterized in that as a scanning beam an electron beam is used.

6. Method as claimed in any one of claims 1 to 5, characterized in that as a scanning beam a cathode beam is used.

7. Method as claimed in claim 1 or 2,

characterized in that the substrate consists of silicon, and the scanning beam is formed by infrared light.

8. Method as claimed in any one of claims 1 to 6, characterized in that the workpiece as a substrate is comprised of transparent material, and that the pattern is comprised of a film layer applied thereon and opaque to the scanning beam, in such a manner that the surfaces of workpiece and pattern have different reflection values for the beam.

**Revendications**

1. Procédé de positionnement et de contrôle d'une pièce munie de dessins, par exemple d'un masque pour la fabrication d'éléments semiconducteurs, au moyen d'un faisceau d,exploration qui produit des signaux différents pour les dessius et pour les autres surfaces de la pièce, avec un système déviateur qui est raccordé à un circuit de commande surveillé par un calculateur et avec un circuit d'interprétation pour les signaux obtenus, caractérisé par le fait que l'on déplace le faisceau d'exploration dans la zone d'un premier côté d'un dessin sélectionné et on mémorise l'information signal ainsi obtenue, que l'on déplace alors le faisceau d'exploration dans la zone d'un deuxième côté, disposé sensiblement parallèlement au premier côté, de ce dessin, et on mémorise également l'information signal ainsi obtenue, la zone étant à chaque fois définie par une surface rectangulaire qui recouvre aussi bien le matériau du dessin que la partie voisine de celui-ci et dont les grands côtés s'étendent parallèlement au premier et au deuxième côté du dessin, et les zones présentant respectivement les memes dimensions, qu'ensuite pour l'interprétation de l'information signal fournie par le faisceau d'exploration et mémorisée, on inverse, puis on intègre l'information signal obtenue lors de l'exploration de la première zone et on intègre sans inversion l'information signal obtenue lors de l'exploration de la deuxième zone, que l'on applique à l'entrée du circuit de commande du faisceau, le signal composite des deux intégrales lequel est proportionnel à l'écart existant entre le côté du dessin et la ligne centrale du faisceau d'exploration, la position du faisceau par rapport au dessin étant ainsi. corrigée en conséquence, que l'on déplace la pièce avec les premier et deuxième côtés mesurés pour l'amener à une position de contrôle présélectionnée et que l'on déplace ensuite le faisceau d'exploration pour le contrôle sur la totalité du dessin et éventuellement d'autres dessins de la pièce.

2. procédé selon la revendication 1, caractérisé par le fait que l'on déplace en plus le faisceau d'exploration dans la zone d'un troisième côté du dessin présélectionné qui est disposé sous un angle prédéterminé par rapport au premier et au deuxième côté et on mémorise l'information signal ainsi obtenue, que l'on déplace ensuite le faisceau dans la zone d'un quatrième côté de cette pièce qui est disposé sensiblement parallèlement au troisième côté, et qu'en interprétant les signaux ainsi obtenus, on déplace la pièce avec les troisième et quatrième côtés mesurés pour l'amenée dans une position de contrôle présélectionnée.

3. Procédé selon la revendication 2, pour le positionnement et le contrôle d'une pièce avec surface non métallisée et dessins formés par des zones métallisées, caractérisé par le fait que l'on dirige le faisceau d'exploration sous forme d'un faisceau d'électrons sur une surface métallisée du dessin de la pièce et on mesure le courant d'électrons réfléchi et secondaire, que l'on dirige ensuite le faisceau d'électrons sur une zone non métallisée de la pièce et on mesure le courant d'électrons réfléchi et secondaire, qu'on établit à partir de là une valeur de seuil entre les deux plages de courant, que l'on déplace le faisceau dans la zone d'un premier côté de la surface métallisée et on mesure le courant d'électrons réfléchi et secondaire, que l'on fait varier la direction .du faisceau de la valeur de la largeur prédéterminée de la surface métallisée et on le déplace dans la zone d'un deuxième côté, parallèle au premier, de la surface métallisée et on mesure le courant d'électrons réfléchi et secondaire, qu'on détermine alors la différence par comparaison des valeurs mesurées, que l'on corrige ensuite la direction du faisceau d'une valeur correspondante, que l'on déplace le faisceau de la meme façon dans les zones d'un troisième et d'un quatrième côte qui sont disposés sous un angle prédéterminé par rapport aux premier et deuxième côtés, et on détermine la différence par comparaison des valeurs mesurées, que l'on corrige alors la direction du faisceau d'une valeur correspondante, que l'on déplace ensuite le faisceau sur la totalite du dessin et on mesure le courant d'électrons réfléchi et que, pour la détection des erreurs on le compare à la valeur de seuil établie.

4. Procédé selon la revendication 3, caractérisé par le fait que l'on dirige le faisceau d'électrons sur une première zone sélectionnée contenant une première marque de repère approximative sélectionnée, on compare l'information signal ainsi obtenue aux données de consigne de la pièce et on ajuste la pièce dans une première position prédéterminée conformément au résultat de la comparaison, qu'on déplace alors le faisceau sur la totalité de la première zone selectionnée et pour la détection des erreurs dans la première zone, on compare l'information signal ainsi obtenue aux données de consigne de la pièce, qu'on dirige ensuite le faisceau sur une deuxième zone sélectionnée contenant une deuxième marque de repère approximative sélectionnée, qu'on compare l'information signal ainsi obtenue aux données de consigne de la pièce et on ajuste la pièce dans une deuxième position prédéterminée conformément au résultat de la comparaison, et qu'on déplace ensuite le faisceau sur la totalité de la deuxième zone sélectionnée et, pour la détection des erreurs dans la deuxième zone, on compare l'information signal ainsi. obtenue aux données de consigne de la pièce.

5. Procédé selon la revendication 1 ou 2, caractérisé par le fait que comme faisceau d'exploration on utilise un faisceau d'électrons.

6. Procédé selon l'une des revendications 1 à 5, caractérisée par le fait que comme faisceau d'exploration on utilise un rayon cathodique.

7. procédé selon la revendication 1 ou 2, caractérisé par le fait que le substrat est en silicium et le faisceau d'exploration est formé par de la lumière infrarouge.

8. Procédé selon l'une des revendications 1 à 6, caractérisé par le fait que la pièce est réalisée sous la forme d'un substrat en matériau transparent et le dessin est réalisé sous la forme d'une couche mince appliquée dessus et non transparente pour le faisceau d'exploration de telle sorte que les surfaces de la pièce et du dessin présentent des valeurs de réflexion différentes pour le faisceau.

FIG. 1

FIG. 2

FIG. 3

1

FIG. 4

FIG. 5

FIG. 6

FIG. 7

FIG. 8

FIG. 9

FIG. 10